# FASCICULE DE BREVET EUROPEEN

(11) **EP 3 939 072 B1**
(45) Date de publication et mention de la délivrance du brevet: **22.02.2023**
(21) Numéro de dépôt: 20713949.4
(22) Date de dépôt: 26.02.2020
(51) Int. Cl.: H01L 21/67

(54) **SYSTÈME DE FRACTURE D'UNE PLURALITÉ D'ASSEMBLAGES DE TRANCHES**
SYSTEM ZUM BRECHEN EINER VIELZAHL VON WAFERANORDNUNGEN
SYSTEM FOR FRACTURING A PLURALITY OF WAFER ASSEMBLIES

(30) Priorité: 15.03.2019 FR 1902680
(43) Date de publication de la demande: 19.01.2022
(73) Titulaire: SOITEC, 38190 Bernin (FR)
(72) Inventeur: LANDRU, Didier, 38190 LE CHAMP-PRES-FROGES (FR); KONONCHUK, Oleg, 38570 THEYS (FR); BEN MOHAMED, Nadia, 38130 ECHIROLLES (FR)
(74) Mandataire: IP Trust
(86) Numéro de dépôt international: PCT/FR2020/050370
(87) Numéro de publication internationale: WO 2020/188170

(56) Documents cités:
- EP-A2- 0 867 917
- WO-A1-03/013815
- FR-A1- 2 919 960
- FR-A1- 2 995 440

## Description

### DOMAINE DE L'INVENTION

La présente invention concerne un système permettant de fracturer au niveau d'un plan de fragilisation deux tranches de matériaux initialement assemblées l'une à l'autre. Ce système est configuré pour traiter collectivement, mais pas nécessairement simultanément, une pluralité de tels assemblages. Le système peut notamment être mis en oeuvre dans une étape de fracture d'un procédé conforme à la technologie Smart Cut^{™} de transfert de couche.

### ARRIERE PLAN TECHNOLOGIQUE DE L'INVENTION

Le document WO2005043615 A1 rappelle que les étapes principales d'un tel procédé comprennent une étape de formation d'un plan de fragilisation dans une tranche de matériaux, dite « tranche donneuse », par exemple par implantation d'espèces légères d'hélium et/ou d'hydrogène. On assemble ensuite cette tranche à une seconde tranche, appelée « tranche support », et on applique un traitement thermique de fragilisation à cet assemblage pour provoquer la fracture de la tranche donneuse au niveau du plan de fragilisation. On transfère de la sorte une couche mince, définie entre la surface d'assemblage de la tranche donneuse et le plan de fragilisation, sur la tranche support. La fracture peut notamment être réalisée par une variété de dispositifs de fracture dont on peut trouver des descriptions dans les documents FR2919960, FR2995440 ou EP867917.

Le document WO2005043615 A1 précité rappelle également que la fracture peut être obtenue spontanément au cours du traitement thermique de fragilisation, lorsqu'un budget thermique suffisant est fourni à l'assemblage. Mais le détachement spontané, pendant le traitement thermique, est parfois mal adapté à certaines situations que le document d'état de la technique énumère de manière détaillée.

Pour pallier ce problème, le document WO2005043615 A1 propose un autre mode de fracture dans lequel on applique le traitement thermique de fragilisation à l'assemblage pour fragiliser suffisamment le plan de fragilisation sans toutefois initier spontanément la fracture. Puis, dans une étape subséquente au traitement thermique, on applique une impulsion d'énergie à l'assemblage de manière à provoquer l'initiation et la propagation d'une onde de fracture auto-entretenue conduisant à détacher la couche mince de la tranche donneuse et à le transférer sur la tranche support. Ce mode de fracture peut-être particulièrement avantageux, notamment parce que l'état de surface de la couche reportée présente généralement une rugosité améliorée vis-à-vis de l'état de surface d'une couche transférée par détachement spontané au cours d'un traitement thermique.

Pour mettre en oeuvre ce procédé avantageux, le document WO2005043615 A1 prévoit de traiter collectivement et simultanément les assemblages de tranches pour les fragiliser thermiquement et leur appliquer l'impulsion d'énergie. Il est ainsi prévu d'employer le dispositif de décollement décrit dans le document WO2003013815 A1 pour appliquer l'impulsion d'énergie simultanément à tout un lot d'assemblages. A cet effet, le dispositif de décollement manipule la pluralité d'assemblages formant le lot, disposée dans une nacelle, à l'aide d'un poussoir pour les placer en position de décollement. On note à ce propos que les assemblages ne sont pas maintenus fermement dans la nacelle d'où ils sont prélevés, et qu'ils sont susceptibles de se déplacer légèrement, ce qui rend leur manipulation délicate. Il referme ensuite sur les assemblages des mâchoires qui, par effet de coins appliqués au niveau des plans de fragilisation des assemblages, tendent à les séparer en deux parties en provoquant l'initiation et la propagation d'ondes de fracture. Les premières parties comprennent les tranches support sur lesquelles les couches minces ont été reportées et les secondes parties les résidus des tranches donneuses. Le dispositif de décollement manipule collectivement ensuite les premières et secondes parties pour les ranger dans des nacelles distinctes afin de pouvoir leur appliquer des traitements complémentaires.

A cours de l'étape de détachement des deux parties, les mâchoires sont respectivement engagées dans des gorges latérales et périphériques des assemblages, définies par des chanfreins périphériques des faces assemblées de la tranche donneuse et de la tranche support. Cette gorge présente des dimensions très petites, de l'ordre de 200 à 300 microns de profondeur et de largeur pour des tranches circulaires de 300mm. Refermer les mâchoires sur tous les assemblages et engager simultanément, très précisément, des coins dans les gorges périphériques des assemblages nécessite une très grande précision, ce qui rend le dispositif complexe, coûteux et peu fiable dans cette application. De plus, si la fracture d'un assemblage n'est pas réalisée correctement, et que les deux parties d'un assemblage ne peuvent donc pas être écartées l'une de l'autre après le renfermement des mâchoires, la manipulation collective des premières et secondes parties du lot qui viennent d'être traitées ne peut être réalisée, et le fonctionnement du dispositif doit être interrompu. D'une manière plus générale, le dispositif de décollement décrit dans le document précité est complexe, car il vise à réaliser à l'aide d'un seul équipement des opérations simultanées de fracture et des opérations de manipulation des assemblages et des parties séparées.

À titre d'illustration additionelle de l'état de l'art, il est aussi possible de se réferrer aux documents suivants:
EP0867917 A2
FR2919960 A1
FR2995440 A1

### OBJET DE L'INVENTION

Un but de l'invention est de remédier au moins en partie aux inconvénients précités. Elle vise plus particulièrement un système de fracture d'assemblages qui soit simple et fiable, et qui ne nécessite pas de manipuler les assemblages individuellement ou collectivement pour réaliser l'opération de fracture.

### BREVE DESCRIPTION DE L'INVENTION

En vue de la réalisation de ce but, l'objet de l'invention propose un système pour fracturer une pluralité d'assemblages de tranches, l'une des tranches de chaque assemblage comprenant un plan de fragilisation et chaque assemblage comprenant une gorge latérale périphérique, le système comportant :
- une nacelle pour maintenir espacés et parallèles les uns aux autres, le long d'un axe de rangement, les assemblages de la pluralité d'assemblages ;
- un dispositif d'écartement pour appliquer des efforts d'écartement dans la gorge périphérique d'un assemblage disposé dans une zone de fracture du dispositif d'écartement, les efforts d'écartement visant à écarter l'une de l'autre les tranches de l'assemblage de manière à initier sa fracture au niveau du plan de fragilisation ;
- un dispositif d'entraînement configuré pour déplacer selon l'axe de rangement la nacelle vis-à-vis du dispositif d'écartement de sorte à placer successivement un assemblage de la nacelle dans la zone de fracture du dispositif d'écartement.

Un tel système de fracture permet de fracturer collectivement une pluralité d'assemblages, sans provoquer cette fracture simultanément sur tous les assemblages et sans manipuler individuellement chaque assemblage. La fracture des assemblages est réalisée alors que ceux-ci sont disposés dans la nacelle. Ces principes permettent de grandement simplifier le système de fracture et de le fiabiliser.

Selon d'autres caractéristiques avantageuses et non limitatives de l'invention, prises seules ou selon toute combinaison techniquement réalisable :
- la distance séparant deux assemblages dans la nacelle est constante ;
- la zone de fracture est configurée pour accueillir un unique assemblage et le dispositif d'écartement traite un unique assemblage à la fois ;
- le dispositif d'entraînement permet de déplacer la nacelle vis-à-vis du dispositif d'écartement à vitesse constante ;
- le dispositif d'entraînement permet de déplacer la nacelle vis-à-vis du dispositif d'écartement pas à pas ;
- le dispositif d'entraînement est un support de nacelle d'un four ;
- la nacelle repose sur le support de nacelle ;
- le dispositif d'écartement est immobile ;
- le dispositif d'écartement est réalisé par un compresseur permettant de générer un jet de fluide à haute pression ;
- le système d'écartement comprend une buse pour mettre en forme le jet de fluide ;
- le système d'écartement comprend un outil disposé à l'extrémité d'un bras mobile ;
- la nacelle est munie d'une pièce d'écartement ;
- la pièce d'écartement porte une pluralité de lames engagées dans les gorges latérales périphériques des assemblages, lorsque ceux-ci sont logés dans la nacelle ;
- le dispositif d'écartement est un dispositif presseur pour appliquer un effort sur un assemblage dirigé vers la pièce d'écartement ;
- le dispositif d'écartement comprend une vis sans fin présentant un filet hélicoïdal, une lame étant disposée dans le filet au droit de la zone de fracture.

Selon un autre aspect, l'invention porte sur un procédé de fracture d'une pluralité d'assemblages de tranches disposée dans une nacelle dans laquelle les assemblages sont maintenus espacés et parallèles les uns aux autres, l'une des tranches de chaque assemblage comprenant un plan de fragilisation et chaque assemblage comprenant une gorge latérale périphérique, le procédé comprenant les étapes suivantes :
- déplacer selon l'axe de rangement la nacelle vis-à-vis d'un dispositif d'écartement de sorte à placer successivement un assemblage de la nacelle dans une zone de fracture du dispositif d'écartement ;
- appliquer, par l'intermédiaire du dispositif d'écartement, des efforts d'écartement dans la gorge périphérique de l'assemblage disposé dans la zone de fracture, les effort d'écartement visant à écarter l'une de l'autre les tranches de l'assemblage de sorte à initier sa fracture au niveau du plan de fragilisation.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1] La figure 1 représente une vue en coupe d'un exemple particulier d'un assemblage à fracturer ;
[Fig. 2] La figure 2 représente l'application d'efforts d'écartement sur un assemblage à fracturer ;
[Fig. 3] La figure 3 représente schématiquement un four horizontal pour appliquer un traitement thermique de fragilisation à une pluralité d'assemblages ;
[Fig. 4] La figure 4 représente un mode de mise en oeuvre préféré du système de fracture ;
[Fig. 5] La figure 5 représente un exemple de nacelle pour maintenir une pluralité d'assemblages ;
[Fig. 6] La figure 6 représente un mode de réalisation du dispositif d'écartement.
[Fig. 7] La figure 7 représente un autre mode de réalisation du dispositif d'écartement.
[Fig. 8] La figure 8 représente un autre mode de réalisation du dispositif d'écartement.

### DESCRIPTION DETAILLEE DE L'INVENTION

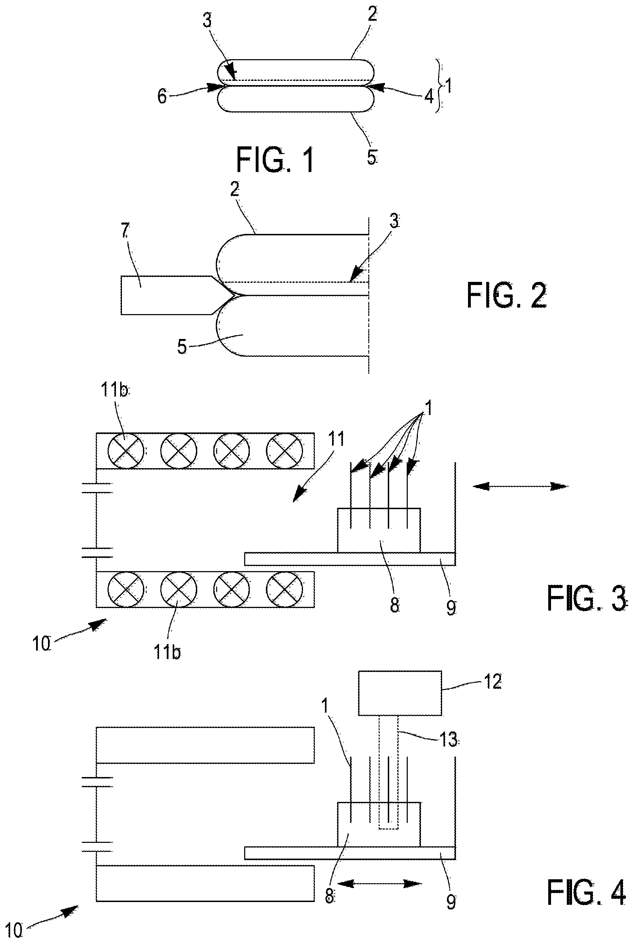

Comme on l'a évoqué en introduction de cette demande, un système de fracture conforme à la présente description est notamment destiné à être mis en oeuvre au cours d'une étape de fracture d'un procédé de transfert de couche, par exemple selon la technologie Smart Cut^{™}. Avant la mise en oeuvre de ce système, et conformément aux étapes préliminaires de cette technologie, on a donc préparé des assemblages composés chacun d'une tranche donneuse et d'une tranche support accolées l'une à l'autre. Chaque tranche de matériau est définie par deux faces principales se faisant face et d'un bord latéral périphérique. Les deux tranches sont accolées respectivement au niveau d'une de leurs faces principales pour former un assemblage. Il est par ailleurs usuel que les tranches de matériau présentent une forme circulaire, mais l'invention n'est nullement limitée à une telle forme. On a représenté sur la figure 1 une vue en coupe d'un exemple particulier d'un tel assemblage 1. Celui-ci est constitué d'une tranche donneuse 2 dans laquelle a été formé, par exemple par implantation d'espèces légères d'hydrogène et/ou d'hélium à travers une face principale de cette tranche 2, un plan de fragilisation 3. Le plan de fragilisation 3 définit, avec une face principale de la tranche donneuse 2, une couche mince 4 que l'on cherche à transférer sur une tranche support 5. On pourra se référer à la littérature abondante décrivant la technologie Smart Cut^{™} pour obtenir plus de détail sur les étapes, et leurs variantes, qui peuvent être mises en oeuvre pour réaliser un tel assemblage 1.

Afin d'éviter les arêtes franches, qui sont susceptibles de se briser et être à l'origine de particules et de défauts, les tranches de matériaux utilisées pour former un assemblage 1 sont généralement pourvues d'un chanfrein annulaire (ou périphérique si ces tranches ne sont pas de formes circulaires). Ce chanfrein peut s'étendre, sur chaque face principale d'une tranche, sur quelques millimètres à la périphérie de cette face.

Lorsque deux tranches sont assemblées l'une à l'autre pour former un assemblage tel que celui représenté sur la figure 1, les chanfreins de chaque tranche se combinent pour constituer une gorge latérale périphérique 6 sur le bord latéral de l'assemblage 1. L'application d'un outil, tel qu'une lame 7, dans la gorge latérale 6 conduit à former des appuis sur les bords des deux tranches 2, 3 qui se font face, et à appliquer un effort dit « d'écartement » sur chacune de ces tranches visant à les écarter l'une de l'autre, comme cela est représenté sur la figure 2. On désignera par « lame » dans la présente description, tout corps présentant la forme d'une lame, c'est-à-dire dont l'extrémité est suffisamment effilée pour s'engager dans la gorge latérale 6, afin de pouvoir appliquer aux tranches des efforts d'écartement. A titre d'exemple, l'extrémité de la lame peut présenter une épaisseur de 200 microns ou moins, et les deux faces de la lame former entre elles un angle de l'ordre de 20°.

Les efforts d'écartement peuvent apporter une énergie suffisante pour provoquer l'initiation d'une onde de fracture au niveau du plan de fragilisation 3 et permettre sa propagation auto entretenue.

Pour permettre ou faciliter ce mode de fracture, le procédé de transfert de couche mettant en oeuvre un système de fracture conforme à l'invention, prévoit de soumettre préalablement l'assemblage 1 à un traitement thermique de fragilisation.

Celui-ci vise à appliquer un budget thermique de fragilisation, insuffisant pour spontanément provoquer la fracture au cours du traitement thermique lui-même, mais conduisant à réduire l'énergie de cohésion du plan 3. Le traitement thermique de fragilisation contribue également à renforcer l'énergie d'adhésion entre les deux tranches donneuse 2 et support 5. Le budget thermique cible, qui peut dépendre de la nature des matériaux constituant les tranches et des espèces formant le plan de fragilisation, peut être déterminé simplement par expérimentation. A titre d'exemple, lorsque les deux tranches sont en silicium et les espèces introduites sont constituées d'hydrogène et éventuellement d'hélium dans une dose totale comprise entre 1e16 at/cm^2 et 1e17 at/cm^2, le traitement thermique de fragilisation peut être compris entre quelques centaines de degrés et 500°C et appliqué pendant une durée de quelques secondes à quelques heures.

Il est industriellement avantageux d'appliquer le traitement de fragilisation à une pluralité d'assemblages 1 simultanément. Et on connaît à cet effet des fours, dit « horizontaux », dans lesquelles plusieurs dizaines d'assemblages 1 peuvent être traités simultanément. Dans un tel four 10, et comme cela est représenté très schématiquement sur la figure 3, une pluralité d'assemblages 1, typiquement 20 à 50 assemblages, sont maintenus verticalement dans une nacelle 8. Une pluralité de nacelles 8 peut être disposée, alignée les unes derrière les autres, sur un support de nacelle 9. Le support de nacelle peut coulisser entre une position de chargement/déchargement dans laquelle le support de nacelle 9 est extrait du four et une position de recuit, dans lequel le support de nacelle 9 est entièrement inséré dans le four 10. Celui-ci est essentiellement constitué d'une chambre 11, dans laquelle l'atmosphère peut être contrôlée, et des éléments de chauffage 11b permettant de déterminer la température de cette atmosphère.

Quelle que soit la manière avec laquelle on a réalisé le traitement thermique de fragilisation, et à l'issue des étapes préliminaires de préparation des assemblages 1, on dispose d'une pluralité d'assemblages 1 de tranches, l'une des tranches 2 de chaque assemblage comprenant un plan de fragilisation 3. Ce plan est suffisamment fragile pour que, pour une majorité de ces assemblages au moins, l'application d'un effort raisonnable au niveau de la gorge latérale périphérique 6 entraîne l'initiation et la propagation auto entretenue d'une onde de fracture.

Pour mettre en oeuvre cette étape de fracture, la présente description prévoit un système de fracture. Celui-ci comprend une nacelle 8 pour maintenir une pluralité d'assemblage 1 maintenus espacés et parallèles les uns des autres le long d'un axe de rangement. On note ici que le maintien des assemblages dans la nacelle n'est pas forcé, et que tous les degrés de liberté des assemblages ne sont pas bloqués, ils sont donc susceptibles de légèrement se déplacer. Il peut s'agir d'une nacelle très conventionnelle comme celle utilisée par exemple pour maintenir des tranches dans un four horizontal, mais l'invention n'est nullement limitée à ce type de nacelle. Plus généralement, on désignera dans cette description par nacelle, tout dispositif permettant de retenir une pluralité d'assemblages 1 espacés et parallèles les uns aux autres le long d'un axe de rangement.

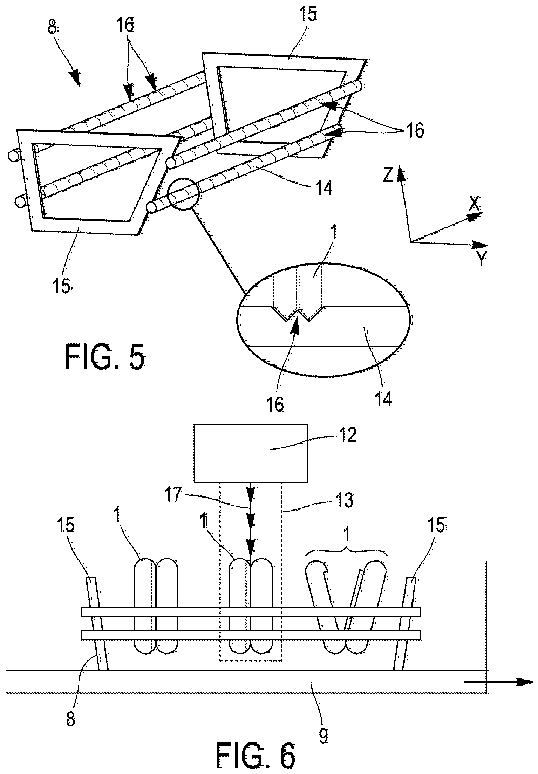

A titre d'exemple, on a représenté sur la figure 5 une nacelle compatible avec la présente description. Cette nacelle 8 est constituée ici de quatre barres longitudinales 14 parallèles entre elles et dont les extrémités sont respectivement solidaires d'une pièce de façade 15 formant également des éléments de soutènement de la nacelle. Les barres longitudinales 14 sont munies d'encoches 16 en regard les unes des autres afin de définir des logements permettant de recevoir et maintenir les assemblages 1. La distance entre deux encoches successives des barres longitudinales définit donc la distance séparant deux assemblages et l'axe de rangement X est colinéaire à ces barres longitudinales. De manière préférée, afin de faciliter la mise en oeuvre du système de fracture et comme cela sera rendu apparent dans la suite de cette description, la distance séparant deux assemblages 1 de la nacelle 8 est constante.

Un système de fracture conforme à la présente description comprend également un dispositif d'écartement 12. Celui-ci vise à appliquer des efforts d'écartement dans la gorge annulaire 6 d'un assemblage 1 en vue de provoquer la fracture de la tranche donneuse lorsque cet assemblage est disposé dans une zone de déclenchement de la fracture 13 du dispositif (et plus simplement désignée « zone de fracture » dans la suite de cet exposé). On détaillera ultérieurement dans la suite de cette description différents moyens mécaniques pouvant être mis en oeuvre par le dispositif d'écartement pour appliquer ces efforts d'écartement. Pour procéder à la fracture d'un assemblage, on dispose donc la nacelle 8 en vis-à-vis du dispositif d'écartement de manière à placer un assemblage 1 de la nacelle 8 dans la zone de fracture 13 (figure 4). Préférentiellement, la zone de fracture 13 permet d'accueillir un unique assemblage et le dispositif d'écartement est configuré pour appliquer les efforts d'écartement visant à provoquer la fracture sur cet unique assemblage. Cette caractéristique permet de constituer un système de fracture particulièrement simple et fiable.

Pour permettre la fracture de la pluralité d'assemblages 1 disposés dans la nacelle 8, on prévoit de déplacer la nacelle 8 vis-à-vis du dispositif d'écartement selon la direction de rangement et ainsi successivement placer un assemblage 1 de la nacelle 8 dans la zone de fracture 13.

A cet effet, le système de fracture comprend un dispositif d'entraînement qui permet de déplacer la nacelle 8 et/ou le dispositif d'écartement l'un par rapport à l'autre. Ce mouvement s'effectue selon l'axe de rangement, de sorte que les assemblages disposés dans la nacelle sont placés successivement les uns après les autres, au cours du déplacement, dans la zone de déclenchement de la fracture.

Avantageusement, le dispositif d'entraînement permet de déplacer la nacelle 8 vis-à-vis du dispositif d'écartement 12 à vitesse constante pendant toute la durée du traitement mis en oeuvre par le système de fracture. Selon une variante, on peut alternativement prévoir que ce déplacement s'effectue pas à pas, pour placer au cours d'étapes de mouvements successifs les assemblages 1 dans la zone de fracture les uns après les autres Un assemblage peut alors résider, immobile, pendant une période de temps déterminée dans la zone de fracture pour y être traité par le dispositif d'écartement. Dans tous les cas, la fracture d'un assemblage est réalisée alors que celui-ci réside dans la nacelle 8, et on évite ainsi la manipulation individuelle ou collective des assemblages, pour les extraire de la nacelle 8 et les positionner en position de fracture. Cette caractéristique est également avantageuse en ce que lors de la fracture d'un assemblage, on évite de placer des éléments en contact avec les faces libres de l'assemblage, par exemple pour la supporter. La demanderesse a en effet observé que ces contacts sur les faces libre de l'assemblage pendant la propagation de l'onde de fracture pouvaient conduire à détériorer la qualité de surface da couche mince transférée sur la tranche support.

Dans le mode préféré de mise en oeuvre du système de fracture représenté sur la figure 5, le dispositif d'entraînement est constitué ou comprend le support de nacelle 9 d'un four horizontal de fragilisation 10, et la nacelle 8 du dispositif de fracture et celle employée pour maintenir les assemblages 1 verticaux dans le four 10. La nacelle 8 est disposée sur le support de nacelle 9. On note que l'on peut placer une pluralité de nacelles 8 sur le support de nacelle 9, et dans ce cas on les disposera les unes derrière les autres selon leurs axes de rangements, afin de pouvoir traiter successivement les assemblages 1 qu'elles contiennent.

Dans ce mode de mise en oeuvre préféré, le dispositif d'écartement 12 est immobile. Il est positionné à proximité de l'ouverture de chargement de la chambre du four 10 de sorte que, lorsque le support de nacelle 9 est déplacé de la position de recuit à la position de chargement/déchargement, par exemple à l'issue du traitement thermique de fragilisation, les assemblages 1 soient disposés successivement, au cours de ce déplacement, dans la zone de fracture 13 pour y être traités les uns après les autres par le dispositif d'écartement 12.

Ce mode de mise en oeuvre préféré est avantageux pour de multiples raisons. En premier lieu, la même nacelle 8 utilisée lors du traitement thermique de fragilisation est employée comme nacelle du système de fracture. Il n'est donc pas nécessaire de manipuler les assemblages 1 pour les placer dans une nouvelle nacelle entre l'étape de traitement thermique et l'étape de fracture, ce qui simplifie l'enchainement de ces étapes et évite tout risque de casse. On tire également profit de la mobilité du support de nacelle 9 pour réaliser le dispositif d'entraînement permettant de déplacer la nacelle et placer successivement les assemblages 1 dans la zone de fracture 13. Il n'est donc pas nécessaire de mettre en oeuvre des moyens additionnels.

Par ailleurs, la configuration dans laquelle le dispositif d'écartement 12 est immobile permet de fixer la distance séparant la zone de fracture 13 de la sortie du four 10. Dans la mesure où la vitesse de déplacement du support 9, selon l'axe de rangement de la nacelle 8, est constante, les assemblages 1 qui se retrouvent successivement dans la zone de fracture 13 ont tous subi la même période de refroidissement et sont donc tous portés à une même température aux instants successifs où ils sont positionnés dans la zone de fracture 13. La température d'un assemblage 1 pouvant influencer l'initiation ou la propagation de l'onde fracture, ce mode de mise en oeuvre assure un traitement identique ou très proche des assemblages 1. Les couches minces 4 reportées sur les tranches support 4 présentent donc toutes des caractéristiques similaires entre elles. De plus, dans le cas accidentel où la fracture d'un assemblage ne se produirait pas parfaitement, il est aisé pour un opérateur d'extraire cet assemblage de la nacelle 8 à l'issue du traitement réalisé par le système de fracture et d'engager les étapes suivantes du procédé avec les assemblages 1 restants de la nacelle 8.

L'invention n'est toutefois nullement limitée au mode préféré de mise en oeuvre qui vient d'être présenté en relation avec la description de la figure 5. On pourrait ainsi choisir d'associer le dispositif d'entraînement au dispositif d'écartement 12, et donc de déplacer ce dispositif alors que la nacelle 8 reste elle immobile. Ce mode de mise en oeuvre est notamment intéressant lorsque le dispositif d'écartement 12 et le dispositif d'entraînement sont tous deux disposés dans la chambre d'un four afin de provoquer mécaniquement la fracture des assemblages 1 in situ, pendant ou à la fin du traitement thermique de fragilisation.

On peut également prévoir que les assemblages 1 soient manipulés juste avant l'étape mise en oeuvre par le système de fracture pour être disposée dans une nacelle dédiée. Cela peut être imposé dans le cas où le traitement thermique de fragilisation ne sont pas mis en oeuvre dans un four horizontal tel que cela a été décrit précédemment, mais dans un autre type de four, par exemple un four du type RTA ou micro-ondes, dans lequel les traitements sont usuellement réalisés plaque à plaque, en l'absence de nacelle.

On peut également prévoir de fracturer une pluralité d'assemblages 1 simultanément, sans toutefois extraire ces assemblages de la nacelle 8. On peut ainsi prévoir plusieurs dispositifs d'écartements et plusieurs zones de fracture, ou alternativement un unique dispositif d'écartement apte à traiter une pluralité d'assemblages disposés dans une même zone de fracture 13.

D'une manière générale, on peut choisir de réaliser le dispositif d'entraînement par tous moyens automatisés de déplacement, par exemple un bras robotisé auquel on pourra solidariser le dispositif d'écartement 12 ou la nacelle 8. Dans tous les cas, le dispositif d'entrainement réalise un déplacement selon l'axe de rangement de la nacelle, que celle-ci soit mobile ou immobile. Et le dispositif d'écartement est agencé vis-à-vis de la nacelle, pour que le mouvement imparti par le dispositif d'entrainement conduise à disposer successivement les assemblages 1 de la nacelle dans la zone de fracture 13.

On détaille maintenant les différents modes de réalisation du dispositif d'écartement 12 pouvant être employés en combinaison avec la nacelle 8 et le dispositif d'entraînement pour former un dispositif de fracture conforme à la présente description. On rappelle en préambule que ce dispositif est configuré pour appliquer des efforts d'écartement dans la gorge latérale périphérique 6 d'un assemblage 1 disposé dans la zone de fracture 13, ces efforts d'écartement visant à écarter l'une de l'autre les tranches de l'assemblage 1 de sorte à initier sa fracture au niveau du plan de fragilisation 3. On note qu'il n'est pas nécessaire que les efforts d'écartement soient de nature impulsionnelle pour permettre de provoquer cette fracture, bien que des efforts de nature impulsionnelle puissent effectivement la provoquer.

### Premier mode de réalisation du dispositif d'écartement

Sur la figure 6, on a représenté un système de fracture dans lequel le dispositif d'écartement 12 est réalisé par un compresseur permettant de générer un jet de fluide 17 à haute pression, par exemple supérieur à 1000 bars. Le compresseur est associé à une buse pour mettre en forme le jet de fluide, pour qu'il présente une dimension réduite, par exemple une section de l'ordre de 1mm^2 ou moins, et agisse ainsi comme une lame. Le fluide est préférentiellement constitué d'un liquide tel que de l'eau pure. Dans l'exemple schématique représenté, la nacelle 8 repose sur un support de nacelle 9 qui se déplace selon l'axe de rangement des assemblages 1 dans cette nacelle, et la nacelle 8 porte trois assemblages 1. Le déplacement peut être celui visant à placer le support de nacelle 9 en position de déchargement à l'issue du traitement thermique de fragilisation. L'assemblage central est précisément disposé dans la zone de fracture 13 du dispositif d'écartement 12, celui-ci produit un jet de fluide 17 qui se projette dans la gorge latérale périphérique de cet assemblage. Le fluide applique des efforts d'écartement sur chacune des tranches composant l'assemblage 1, ce qui conduit à initier et à propager l'onde de fracture.

L'assemblage 1 disposé en aval de celui placé dans la zone de fracture 13 a été préalablement traité par le jet de fluide 17. Il apparaît donc fracturé sur cette figure, et les deux parties composant initialement l'assemblage 1, de part et d'autre du plan de fragilisation, sont séparées l'une de l'autre. On peut prévoir que certaines des encoches 14 dont sont munies les barres longitudinales 16 de la nacelle 8, présentent un profil en V ou en W, permettant de maintenir séparés les deux parties après la fracture de l'assemblage 1 sans qu'elles n'entrent en contact avec les assemblages adjacents.

L'assemblage 1 disposé en amont de celui placé dans la zone de fracture 13 n'a pas encore été fracturé. Le déplacement suivant l'axe de rangement, symbolisé par la flèche X sur la figure 6, va conduire à placer cet assemblage dans la zone de fracture 13.

Le jet de fluide 17 peut être continu de sorte que, au fur et à mesure du déplacement du dispositif d'entrainement, chaque assemblage 1 sera successivement soumis aux efforts appliqués par le jet 17, celui-ci s'engageant à un instant particulier de son passage dans la zone de fracture 13 dans la gorge périphérique pour provoquer sa fracture. Alternativement, le jet peut être intermittent, et interrompu durant les périodes pendant lesquels aucun assemblage 1 n'est présent dans la zone de fracture 13. On peut dans ce cas prévoir de séquencer des étapes de déplacements pas à pas du dispositif d'entrainement, ici le support de nacelle, afin de placer successivement immobile un assemblage 1 dans la zone de fracture 13, avec des étapes de génération du jet de fluide 17. On peut prévoir de munir le dispositif d'écartement 12 d'un détecteur permettant de repérer la présence ou le passage d'un assemblage dans la zone de fracture 13 et d'initier et interrompre la génération du jet 17 conformément. On peut prévoir, dans ce mode intermittent, de placer plusieurs assemblages dans une zone de fracture 13, qui seront traités par plusieurs jets de fluide issus du compresseur. Ce premier mode de réalisation est avantageux en ce qu'il résout le problème du positionnement précis du dispositif d'écartement en vis à vis de la gorge latérale périphérique, le jet de fluide s'engageant naturellement dans cette gorge lors du passage de la l'assemblage sous ce jet.

### Deuxième mode de réalisation du dispositif d'écartement

Dans une variante non représentée du premier mode de réalisation, le dispositif d'écartement est constitué d'un outil, telle qu'une lame, disposé à l'extrémité d'un bras mobile. L'outil est destiné à s'insérer dans la gorge latérale périphérique 6 d'un assemblage 1 disposé dans la zone de fracture 13 et à appliquer des efforts visant à initier la fracture de l'assemblage 1. L'insertion de l'outil dans la gorge peut être réalisé en commandant le bras mobile lorsque l'on détecte que l'assemblage est bien présent dans la zone de fracture 13. Le fonctionnement de cette variante est très proche de celle du premier mode de réalisation mettant en oeuvre un jet de fluide intermittent, et par soucis de concision on s'abstient de reproduire ici toutes les caractéristiques qui peuvent s'appliquer, qui ont déjà été décrites en relation avec ce premier mode de réalisation.

### Troisième mode de réalisation du dispositif d'écartement

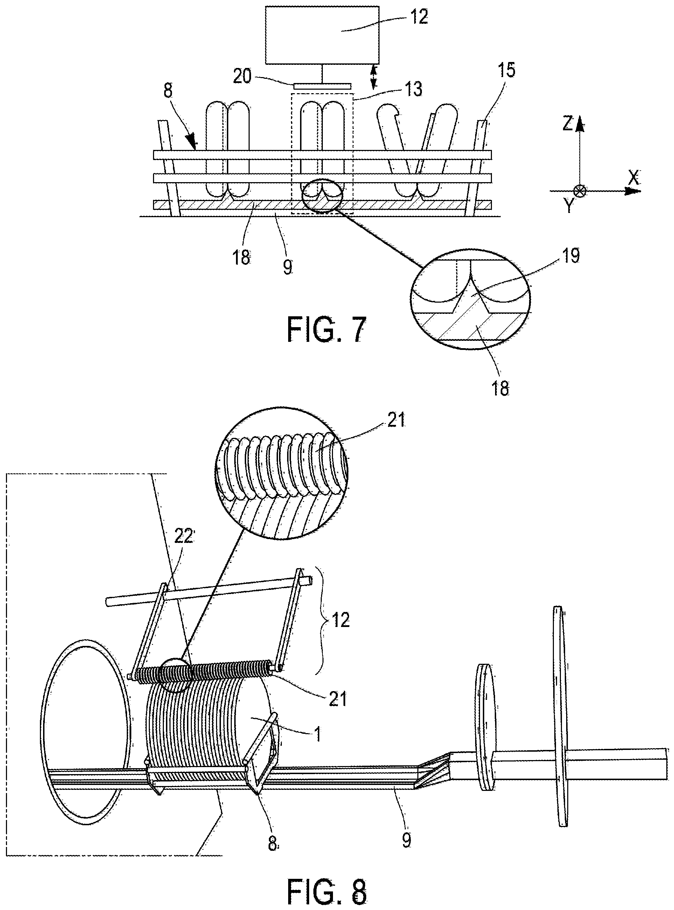

La figure 7 représente un autre mode de réalisation d'un dispositif d'écartement. Dans ce mode de réalisation, la nacelle 8 est munie d'une pièce d'écartement 18. Cette pièce 18 peut être maintenue aux extrémités de la nacelle 8 par les façades 15 tout comme le sont les barres longitudinales 14. La pièce d'écartement 18 est munie de lames 19 dont les extrémités sont respectivement configurées pour pouvoir se loger dans la gorge périphérique des assemblages 1 disposés dans la nacelle 8. La position des lames 19 le long de la pièce d'écartement 18 correspond donc à celle des encoches 16 dont peuvent être munies les barres longitudinales 14, de sorte que lorsque les assemblages sont placés dans leurs logements respectifs dans la nacelle 8, une lame 19 est également engagée dans chacune des gorges latérales périphériques. Comme cela est bien visible sur l'insert de la figure 7, la lame présente une longueur telle que son extrémité est en contact avec le fond de la gorge sans que le bord périphérique des tranches de l'assemblage ne reposent sur la pièce d'écartement 18, de part et d'autre de la lame 19.

La pièce d'écartement 18 est ici disposée sur la nacelle de manière à être située sous les assemblages 1 lorsque ceux-ci sont logés dans leurs encoches. On pourrait toutefois prévoir de placer la pièce écartement 18 à un autre endroit de la nacelle 8, par exemple sur un coté de cette nacelle. On pourrait également prévoir plusieurs pièces d'écartement 18 de manière engager plusieurs lames dans chaque gorge 6.

Le dispositif d'écartement 12 comprend, dans ce troisième mode de réalisation, un dispositif presseur 20 configuré pour appliquer un effort transversal, c'est à dire essentiellement compris dans le plan (Y, Z) reproduit sur la figure, sur le bord périphérique de l'assemblage 1 disposé dans la zone de fracture 13. Cet effort est dirigé, ou présente une composante dirigée, vers la pièce d'écartement 18 portant les lames 19.

En fonctionnement, lorsqu'un assemblage 1 est positionné dans la zone de fracture 13, le dispositif presseur 20 est activé pour venir prendre appui sur le bord périphérique de cet assemblage. Cet appui peut être très bref, pour ne pas gêner le mouvement de déplacement du dispositif d'entrainement, par exemple du support de nacelle 9, lorsque ce mouvement est continu. L'appui sur le bord de l'assemblage 1 force l'engagement de la lame 19 de la pièce d'écartement 18 dans la gorge périphérique, ce qui conduit à appliquer les efforts d'écartement visant à initier l'onde de fracture au niveau du plan de fragilisation et de provoquer sa propagation pour détacher l'assemblage en deux parties.

En comparaison avec le deuxième mode de réalisation mettant en oeuvre un outil disposé à l'extrémité d'un bras mobile, ce troisième mode de réalisation est avantageux en ce qu'il ne nécessite pas de placer dynamiquement l'outil dans la gorge de l'assemblage 1, ce qui peut nécessiter une très grande précision. L'outil, c'est-à-dire la lame 19, est ici pré-positionné dans la gorge périphérique de chacun des assemblages 1 de la nacelle 8, et il suffit d'appliquer un effort de poussée sur chaque assemblage 1 pour provoquer la fracture. Cet effort de poussée peut être parfaitement contrôlé en intensité et il n'est pas nécessaire qu'il présente une grande précision de positionnement. On peut dès lors envisager d'utiliser ce dispositif d'écartement en combinaison avec un déplacement continu ou pas à pas de la nacelle 8, indifféremment. Tout comme le premier mode de réalisation, ce troisième mode est avantageux en ce qu'il résout le problème du positionnement précis du dispositif d'écartement en vis à vis de la gorge latérale périphérique, en pré-positionnant une lame dans chaque gorge des assemblages.

### Quatrième mode de réalisation du dispositif d'écartement

La figure 8 représente un quatrième mode de réalisation d'un dispositif d'écartement 12. On retrouve dans ce mode de réalisation le dispositif d'entraînement, ici un support de nacelle 9, une nacelle conventionnelle 8 dans laquelle sont disposés une pluralité d'assemblages 1, logés dans les encoches 16 des barres longitudinales 14. Ce mode de réalisation prévoit que le dispositif d'entraînement déplace la nacelle 8 de manière continue, avec une vitesse sensiblement constante, bien que cela ne forme pas une condition nécessaire à son fonctionnement.

Le dispositif d'écartement 12 est ici formé d'une vis sans fin 21 dont l'axe s'étend selon l'axe de rangement des assemblages 1 dans la nacelle 8. La vis 21 présente un filet s'enroulant de manière hélicoïdale. Le pas de la vis correspond à la distance constante séparant deux assemblages 1 consécutivement logés dans la nacelle. On pourrait également prévoir que l'écartement entre deux assemblages 1 de la nacelle 8 soit un multiple du pas de vis.

La vis 21 formant le dispositif d'écartement 12 est agencée vis-à-vis de la nacelle 8 pour que le bord des assemblages 1 puisse s'engager dans le filet de la vis. Comme cela est représenté sur la figure, la vis 21 peut être retenue par un support 22, dans lequel elle est libre d'entrer en rotation. Le support 22 est amovible, permettant de positionner la vis 21 dans une première position dans laquelle les bords des assemblages sont susceptibles de se loger dans le filet, ou de positionner la vis dans une seconde position, non active. Le déplacement de la nacelle 8 par l'intermédiaire du dispositif d'entraînement 12 conduit à entraîner en rotation la vis sans fin 21 tout en maintenant les assemblages 1 engagés dans le filet. Chaque assemblage 1 sera donc guidé par le filet de la vis d'une extrémité à l'autre de cette vis 21 au cours de son déplacement. La vis 21 peut exercer une légère pression sur le bord des assemblages 1 pour maintenir la cohésion de l'ensemble au cours du déplacement du dispositif d'entrainement.

On peut également prévoir que la vis 21 soit entraînée en rotation par un dispositif moteur à laquelle elle serait associée, la rotation de cette vis étant coordonnée à la vitesse de déplacement du dispositif d'entrainement. On limite ainsi la pression qu'exercent les assemblages sur le filet de la vis sans fin pour l'entrainer en rotation.

Comme cela est bien visible sur la figure 8, la vis porte une lame en un endroit déterminé de son filet, au droit de la zone de fracture 13. Lorsqu'un assemblage 1 est déplacé pour entrer dans la zone de fracture 13, la rotation de la vis sans fin force l'engagement de la lame dans la gorge périphérique de cet assemblage 1. Tout comme dans le mode de réalisation précédent, l'engagement forcé de la lame dans la gorge provoque l'initiation d'une onde de fracture et sa propagation le long du plan de fragilisation.

Bien entendu l'invention n'est pas limitée aux modes de mise en oeuvre du système de fracture et aux modes de réalisation du dispositif d'écartement décrits et on peut y apporter des variantes de réalisation sans sortir du cadre de l'invention tel que défini par les revendications.

## Revendications

1. Système pour fracturer une pluralité d'assemblages de tranches (1), l'une des tranches (2) de chaque assemblage (1) comprenant un plan de fragilisation (3) et chaque assemblage (1) comprenant une gorge latérale périphérique (6), le système comportant :
- une nacelle (8) pour maintenir espacés et parallèles les uns aux autres, le long d'un axe de rangement, les assemblages (1) de la pluralité d'assemblages;
- un dispositif d'écartement (12) pour appliquer des efforts d'écartement dans la gorge périphérique (6) d'un assemblage (1) disposé dans une zone de fracture (13) du dispositif d'écartement, les effort d'écartement visant à écarter l'une de l'autre les tranches (2, 5) de l'assemblage (1) de sorte à initier sa fracture au niveau du plan de fragilisation (3),
le système étant **caractérisé en ce qu'**il comprend de plus:
- un dispositif d'entraînement configuré pour déplacer selon l'axe de rangement la nacelle (8) vis-à-vis du dispositif d'écartement de sorte à placer successivement un assemblage (1) de la nacelle (8) dans la zone de fracture (13) du dispositif d'écartement.

2. Système pour fracturer selon la revendication précédente dans lequel la distance séparant deux assemblages (1) dans la nacelle (8) est constante.

3. Système pour fracturer selon l'une des revendications précédentes dans lequel la zone de fracture (13) est configurée pour accueillir un unique assemblage (1) et le dispositif d'écartement (12) traite un unique assemblage à la fois.

4. Système pour fracturer selon l'une des revendications précédentes dans lequel le dispositif d'entraînement permet de déplacer la nacelle (8) vis-à-vis du dispositif d'écartement (12) à vitesse constante.

5. Système pour fracturer selon l'une des revendications 1 à 3 dans lequel le dispositif d'entraînement permet de déplacer la nacelle (8) vis-à-vis du dispositif d'écartement (12) pas à pas.

6. Système pour fracturer selon l'une des revendications précédentes dans lequel le dispositif d'entraînement est un support de nacelle (9) d'un four (10).

7. Système pour fracturer selon la revendication précédente dans lequel la nacelle (8) repose sur le support de nacelle (9) .

8. Système pour fracturer selon l'une des revendications précédentes dans lequel le dispositif d'écartement (12) est immobile.

9. Système pour fracturer selon l'une des revendications précédentes dans lequel le dispositif d'écartement (12) est réalisé par un compresseur permettant de générer un jet de fluide (17) à haute pression.

10. Système pour fracturer selon la revendication précédente dans lequel le dispositif d'écartement (12) comprend une buse pour mettre en forme le jet de fluide (17) .

11. Système pour fracturer selon l'une des revendications 1 à 8 dans lequel le système d'écartement (12) comprend un outil disposé à l'extrémité d'un bras mobile.

12. Système pour fracturer selon l'une des revendications 1 à 8 dans lequel la nacelle (8) est munie d'une pièce d'écartement (18).

13. Système pour fracturer selon la revendication précédente dans lequel la pièce d'écartement (18) porte une pluralité de lames (19) engagées dans les gorges latérales périphériques (6) des assemblages (1), lorsque ceux-ci sont logés dans la nacelle (8).

14. Système pour fracturer selon l'une des deux revendications précédentes dans lequel le dispositif d'écartement (12) est un dispositif presseur (20) pour appliquer un effort sur un assemblage dirigé vers la pièce d'écartement (18).

15. Système pour fracturer selon l'une des revendications 1 à 8 dans lequel le dispositif d'écartement (12) comprend une vis sans fin (21) présentant un filet hélicoïdal, une lame étant disposée dans le filet au droit de la zone de fracture (13).

16. Procédé de fracture d'une pluralité d'assemblages (1) de tranches (2, 5) disposée dans une nacelle (8) dans laquelle les assemblages (1) sont maintenus espacés et parallèles les uns aux autres, l'une des tranches (2) de chaque assemblage (1) comprenant un plan de fragilisation (3) et chaque assemblage (1) comprenant une gorge latérale périphérique (6), le procédé comprenant les étapes suivantes :
- déplacer selon l'axe de rangement la nacelle (8) vis-à-vis d'un dispositif d'écartement (12) de sorte à placer successivement un assemblage (1) de la nacelle dans une zone de fracture (13) du dispositif d'écartement (12) ;
- appliquer, par l'intermédiaire du dispositif d'écartement (12), des efforts d'écartement dans la gorge latérale périphérique (6) de l'assemblage (1) disposé dans la zone de fracture (13), les effort d'écartement visant à écarter l'une de l'autre les tranches (2, 5)de l'assemblage (1) de sorte à initier sa fracture au niveau du plan de fragilisation (3).

## Patentansprüche

1. System zum Brechen einer Vielzahl von Waferanordnungen (1), wobei einer der Wafer (2) einer jeden Anordnung (1) eine Versprödungsebene (3) umfasst und jede Anordnung (1) eine seitliche Umfangskerbe (6) umfasst, wobei das System aufweist:
- eine Aufnahmevorrichtung (8), um die Anordnungen (1) der Vielzahl von Anordnungen entlang einer Aufreihungsachse zueinander beabstandet und parallel zu halten;
- eine Spreizvorrichtung (12), um in der Umfangskerbe (6) einer in einer Brechzone (13) der Spreizvorrichtung angeordneten Anordnung (1) Spreizkräfte anzuwenden, wobei die Spreizkräfte das Spreizen der Wafer (2, 5) der Anordnung (1) voneinander derart bewirken sollen, dass bei ihr das Brechen im Bereich der Versprödungsebene (3) eingeleitet wird, wobei das System **dadurch gekennzeichnet ist, dass** es ferner umfasst:
- eine Antriebsvorrichtung, die dazu ausgelegt ist, die Aufnahmevorrichtung (8) entlang der Aufreihungsachse gegenüber der Spreizvorrichtung derart zu verfahren, dass nacheinander eine Anordnung (1) der Aufnahmevorrichtung (8) in der Brechzone (13) der Spreizvorrichtung platziert wird.

2. System zum Brechen nach dem vorhergehenden Anspruch, wobei der Abstand, durch den zwei Anordnungen (1) in der Aufnahmevorrichtung (8) getrennt sind, konstant ist.

3. System zum Brechen nach einem der vorhergehenden Ansprüche, wobei die Brechzone (13) derart ausgebildet ist, dass sie eine einzelne Anordnung (1) aufnimmt und die Spreizvorrichtung (12) jeweils eine einzelne Anordnung verarbeitet.

4. System zum Brechen nach einem der vorhergehenden Ansprüche, wobei die Antriebsvorrichtung es ermöglicht, die Aufnahmevorrichtung (8) mit konstanter Geschwindigkeit gegenüber der Spreizvorrichtung (12) zu verfahren.

5. System zum Brechen nach einem der Ansprüche 1 bis 3, wobei die Antriebsvorrichtung es ermöglicht, die Aufnahmevorrichtung (8) schrittweise gegenüber der Spreizvorrichtung (12) zu verfahren.

6. System zum Brechen nach einem der vorhergehenden Ansprüche, wobei die Antriebsvorrichtung ein Träger einer Aufnahmevorrichtung (9) eines Ofens (10) ist.

7. System zum Brechen nach dem vorhergehenden Anspruch, wobei die Aufnahmevorrichtung (8) auf dem Träger der Aufnahmevorrichtung (9) aufliegt.

8. System zum Brechen nach einem der vorhergehenden Ansprüche, wobei die Spreizvorrichtung (12) stationär ist.

9. System zum Brechen nach einem der vorhergehenden Ansprüche, wobei die Spreizvorrichtung (12) durch einen Verdichter gebildet wird, der es ermöglicht, einen Fluidstrahl (17) mit hohem Druck zu erzeugen.

10. System zum Brechen nach dem vorhergehenden Anspruch, wobei die Spreizvorrichtung (12) eine Düse zum Ausbilden der Form des Fluidstrahls (17) umfasst.

11. System zum Brechen nach einem der Ansprüche 1 bis 8, wobei das Spreizsystem (12) ein am Ende eines beweglichen Arms angeordnetes Werkzeug umfasst.

12. System zum Brechen nach einem der Ansprüche 1 bis 8, wobei die Aufnahmevorrichtung (8) mit einem Spreizelement (18) versehen ist.

13. System zum Brechen nach dem vorhergehenden Anspruch, wobei das Spreizelement (18) eine Vielzahl von Klingen (19) trägt, die in die seitlichen Umfangskerben (6) der Anordnungen (1) eingreifen, wenn diese in der Aufnahmevorrichtung (8) aufgenommen sind.

14. System zum Brechen nach einem der beiden vorhergehenden Ansprüche, wobei die Spreizvorrichtung (12) eine Druckvorrichtung (20) ist, um eine Kraft auf eine zu dem Spreizelement (18) hin ausgerichtete Anordnung anzuwenden.

15. System zum Brechen nach einem der Ansprüche 1 bis 8, wobei die Spreizvorrichtung (12) eine ein spiralförmiges Gewinde aufweisende Endlosschnecke (21) umfasst, wobei in dem Gewinde direkt zur Brechzone (13) ausgerichtet eine Klinge angeordnet ist.

16. Verfahren zum Brechen einer Vielzahl von Anordnungen (1) von Wafern (2, 5), die in einer Aufnahmevorrichtung (8) angeordnet ist, in der die Anordnungen (1) beabstandet und parallel zueinander gehalten werden, wobei einer der Wafer (2) einer jeden Anordnung (1) eine Versprödungsebene (3) umfasst und jede Anordnung (1) eine seitliche Umfangskerbe (6) umfasst, wobei das Verfahren die folgenden Schritte umfasst:
- Verfahren der Aufnahmevorrichtung (8) entlang der Aufreihungsachse gegenüber einer Spreizvorrichtung (12) derart, dass nacheinander eine Anordnung (1) der Aufnahmevorrichtung in einer Brechzone (13) der Spreizvorrichtung (12) platziert wird;
- Anwenden von Spreizkräften mittels der Spreizvorrichtung (12) in der seitlichen Umfangskerbe (6) der in der Brechzone (13) angeordneten Anordnung (1), wobei die Spreizkräfte das Spreizen der Wafer (2, 5) der Anordnung (1) voneinander derart bewirken sollen, dass bei ihr das Brechen im Bereich der Versprödungsebene (3) eingeleitet wird.

## Claims

1. System for fracturing a plurality of assemblies of wafers (1), one of the wafers (2) of each assembly (1) comprising an embrittlement plane (3) and each assembly (1) comprising a peripheral lateral groove (6), the system comprising:
- a pod (8) for holding the assemblies (1) of the plurality of assemblies spaced apart and parallel to each other along a storage axis;
- a spreading device (12) for applying spreading forces in the peripheral groove (6) of an assembly (1) arranged in a fracture zone (13) of the spreading device, the spreading forces being intended to spread the wafers (2, 5) of the assembly (1) apart so as to initiate the fracture thereof at the embrittlement plane (3),
the system being **characterized in that** it further comprises:
- a drive device configured to move the pod (8) along the storage axis relative to the spreading device so as to successively place an assembly (1) of the pod (8) in the fracture zone (13) of the spreading device.

2. Fracturing system according to the preceding claim, wherein the distance separating two assemblies (1) in the pod (8) is constant.

3. Fracturing system according to either of the preceding claims, wherein the fracture zone (13) is designed to accommodate a single assembly (1) and the spreading device (12) processes a single assembly at a time.

4. Fracturing system according to any of the preceding claims, wherein the drive device makes it possible to move the pod (8) relative to the spreading device (12) at constant speed.

5. Fracturing system according to any of claims 1 to 3, wherein the drive device makes it possible to move the pod (8) relative to the spreading device (12) gradually.

6. Fracturing system according to any of the preceding claims, wherein the drive device is a pod support (9) of a furnace (10).

7. Fracturing system according to the preceding claim, wherein the pod (8) rests on the pod support (9).

8. Fracturing system according to any of the preceding claims, wherein the spreading device (12) is stationary.

9. Fracturing system according to any of the preceding claims, wherein the spreading device (12) is realized by a compressor for generating a jet of fluid (17) at high pressure.

10. Fracturing system according to the preceding claim, wherein the spreading device (12) comprises a nozzle for shaping the jet of fluid (17).

11. Fracturing system according to any of claims 1 to 8, wherein the spreading system (12) comprises a tool arranged at the end of a movable arm.

12. Fracturing system according to any of claims 1 to 8, wherein the pod (8) is provided with a spreader (18).

13. Fracturing system according to the preceding claim, wherein the spreader (18) has a plurality of blades (19) engaged in the peripheral lateral grooves (6) of the assemblies (1) when the latter are housed in the pod (8).

14. Fracturing system according to either of the two preceding claims, wherein the spreading device (12) is a pressure device (20) for applying a force to an assembly directed toward the spreader (18).

15. Fracturing system according to any of claims 1 to 8, wherein the spreading device (12) comprises an endless screw (21) having a helical thread, a blade being arranged in the thread in line with the fracture zone (13).

16. Method for fracturing a plurality of assemblies (1) of wafers (2, 5) arranged in a pod (8) in which the assemblies (1) are held spaced apart and parallel to each other, one of the wafers (2) of each assembly (1) comprising an embrittlement plane (3) and each assembly (1) comprising a peripheral lateral groove (6), the method comprising the following steps:
- moving the pod (8) along the storage axis relative to a spreading device (12) so as to successively place an assembly (1) of the pod in a fracture zone (13) of the spreading device (12);
- applying, via the spreading device (12), spreading forces in the peripheral lateral groove (6) of the assembly (1) arranged in the fracture zone (13), the spreading forces being intended to spread the wafers (2, 5) of the assembly (1) apart so as to initiate the fracture thereof at the embrittlement plane (3).
